**Europäisches Patentamt**

**European Patent Office**

**Office européen des brevets**

(19)

(11) Veröffentlichungsnummer: **0 301 470 B1**

(12)

# EUROPÄISCHE PATENTSCHRIFT

(45) Veröffentlichungstag der Patentschrift: **14.10.92**

(51) Int. Cl.⁵: **H01L 31/02**, H01L 31/18

(21) Anmeldenummer: **88112007.5**

(22) Anmeldetag: **26.07.88**

(54) **Verkapselung von einem photovoltaischen Element.**

(30) Priorität: **30.07.87 DE 3725338**

(43) Veröffentlichungstag der Anmeldung:
**01.02.89 Patentblatt 89/05**

(45) Bekanntmachung des Hinweises auf die
Patenterteilung:
**14.10.92 Patentblatt 92/42**

(84) Benannte Vertragsstaaten:
**DE ES FR IT SE**

(56) Entgegenhaltungen:
**DE-A- 3 125 622**
**FR-A- 2 428 920**
**GB-A- 1 136 218**
**US-A- 4 383 129**

**PATENT ABSTRACTS OF JAPAN, Band 10,
Nr. 8 (E-373)[2065], 14. Januar 1986; & JP-
A-60 170 980**

(73) Patentinhaber: **Nukem GmbH
Industriestrasse 13
W-8755 Alzenau(DE)**

(72) Erfinder: **Huschka, Hans, Dr. Dipl.-Chem.
Grünaustrasse 5
W-6450 Hanau 9(DE)**
Erfinder: **Hoffmann, Winfried, Dr. Dipl.-Phys.
Bergstrasse 48
W-6450 Hanau 7(DE)**

(74) Vertreter: **Stoffregen, Hans-Herbert, Dr.
Dipl.-Phys.
Patentanwalt, Salzstrasse 11 a, Postfach 21
44
W-6450 Hanau (Main) 1(DE)**

## Beschreibung

Die Erfindung bezieht sich auf eine Verkapselung von einem photovoltaischen Element wie Solarzelle oder Solarzellenmodul, wobei zumindest dessen freie Außenfläche mit einer transparenten Schutzschicht abgedeckt ist, die aus einer dielektrischen Siliziumverbindung besteht, sowie auf ein Verfahren zur Durchführung einer entsprechenden Verkapselung.

Solarzellen oder aus diesen bestehende Module oder Panels für die photovoltaische Stromerzeugung werden sowohl innerhalb als auch außerhalb von Räumen eingesetzt. Hauptanwendungsgebiet ist jedoch die Nutzung im Freien z.B. zur Energieerzeugung für Einfamilienhäuser, Pumpen, Kühlaggregate, Boote und ähnliches. Hierdurch bedingt sind sie einer Vielzahl von Störungen durch z.B. Witterung, Staub, Schmutz und ähnliches ausgesetzt. Aus diesem Grunde müssen die stromerzeugenden und -ableitenden Teile und die Verschaltung zwischen den einzelnen Zellen vor entsprechenden Einflüssen geschützt werden. So ist es bekannt, Solarzellen durch Aufkleben von Spezialglas- oder Quarzglasscheiben, transparentem Kunststoff oder mit Kunststoff beschichteten Metallfolien auf der Rückseite der Zellen zu verkapseln. Diese Deckplatten, zwischen denen die Solarzelle liegt, werden von einem Rahmen gefaßt und abgedichtet. Zwischen den Deckplatten und den Zellen können zusätzlich noch transparente organische Materialien eingebracht werden. Die Materialauswahl hat dabei unter den Gesichtspunkten zu erfolgen:

- gute optische Eigenschaften (Durchlässigkeit, Brechungsindex), die durch Bestrahlung mit Sonnenlicht nicht verschlechtert werden dürfen,
- mechanische und thermische Eigenschaften (Bruchfestigkeit, Stoßfestigkeit, Temperaturbeständigkeit, thermische Ausdehnung, Dichtheit),
- Widerstandsfähigkeit gegen mechanische und chemische Einwirkungen (Erosion, Korrosion, Verunreinigung),
- Widerstandsfähigkeit gegen alle Wetterbedingungen.

Entsprechende Verkapselungstechniken zeigen erhebliche Nachteile, die sich sowohl durch die Vielzahl der verwendeten unterschiedlichen Materialien, die miteinander in Berührung gelangen, als auch durch die aufwendigen und umständlichen Fertigungstechnologien ergeben. Dabei erwachsen zusätzliche Probleme dann, wenn die Größe der zu verkapselnden bzw. zu versiegelnden Fläche zunimmt. Da außerdem bei der Materialauswahl Kompromisse eingegangen werden müssen, tritt eine Bruchgefahr des Glases oder eine Unbeständigkeit von organischem Material gegen langzeitige Licht- und Umwelteinflüsse auf. Auch können die unterschiedlichen thermischen Eigenschaften der aneinandergrenzenden Materialien zu Bruch und Schäden der photovoltaischen Zellen und Modulen führen, wenn ein Einsatz mit starken Temperaturwechselbeanspruchungen erfolgt.

Aufgabe der vorliegenden Erfindung ist es, eine Verkapselung von einem photovoltaischem Element der eingangs beschriebenen Art zur Verfügung zu stellen, die eine hohe Widerstandsfähigkeit gegen mechanische, chemische Einwirkungen und gegen Wettereinflüsse zeigt, wobei gleichzeitig gute optische, mechanische und thermische Eigenschaften gewährleistet sein sollen. Auch soll die Verkapselungsherstellungstechnik einfach und kostengünstig erfolgen können.

Die Aufgabe wird erfindungdgemäß durch die Merkmale des Patentanspruchs 1 gelöst. Vorzugsweise besteht die äußere Schicht aus dem Kohlenstoff und die innenliegende Schicht aus der dielektrischen Siliziumverbindung vorzugsweise aus Siliziumnitrid oder Siliziumoxinitrid. In Ausgestaltung ist die Dicke einer jeden Schicht kleiner als 10 $\mu$m, wobei die Summe beider Schichten kleiner als 15 $\mu$m sein sollte. Insbesondere ergibt sich dann eine optimale Verkapselung, wenn die Dicke der aus Kohlenstoff bestehenden Schicht kleiner als 1 $\mu$m und die der Siliziumverbindung kleiner 5 $\mu$m ist.

Ein Verfahren zur Verkapselung eines photovoltaischen Elementes wie Solarzelle oder Solarzellenmodul, wobei zumindest dessen freie Außenfläche mit einer transparenten Schutzschicht aus einer dielektrischen Siliziumverbindung abgedeckt wird, zeichnet sich dadurch aus, daß durch plasma- bzw. mikrowellengestütztes Abscheiden aus der Gasphase (CVD) die dielektrische Siliziumverbindung in Form von Siliziumnitrid- oder -oxinitrid-Schicht bei maximal 500°C des photovoltaischen Elementes und eine amorphe Kohlenstoffschicht bei maximal 200°C des photovoltaischen Elementes aufgetragen wird. Dabei erfolgt vorzugsweise bei Ausbildung der Schicht aus amorphem Kohlenstoff eine Abscheidung in einer Plasmaglimmentladung bei einer Temperatur $T_1$ mit $T_1 \leq 200°C$ vorzugsweise $60°C \leq T_1 \leq 100°C$. Der kristalline Kohlenstoff wird in einer Mikrowellen-Plasma-CVD-Anlage bei Temperaturen $T_2$ mit $T_2 \leq 1000°C$, vorzugsweise $750°C \leq T_2 \leq 950°C$ abgeschieden. Sofern die Schicht aus einer dielektrischen Siliziumverbindung besteht, erfolgt ein Abscheiden aus einem Silan-Ammoniak-Plasma bei einer Temperatur $T_3$ des Elementes mit $230°C \leq T_3 \leq 450°C$ vorzugsweise $260° \leq T_3 \leq 280°C$.

Durch die erfindungsgemäße Lehre erfolgt eine Verkapselung bzw. Versiegelung von photovoltaischen Elementen wie Solarzellen oder Solarzellenmodulen, die sowohl korrosion als auch abrasiven Schutz geben und die gegebenenfalls in einem kontinuierlichen Prozeß auf beliebig große Flächen aufgebracht werden können. In nicht vorherzusehender Weise ergibt sich außerdem eine Haftfestigkeit sowie Verträglichkeit, die ohne Beeinflussung der Transparenz eine hohe Widerstandsfähigkeit gegenüber Witterungseinflüssen, mechanischen und chemischen Einwirkungen sowie thermischen Beeinflussungen zeigt. Verfahrensmäßig ergibt sich der Vorteil, daß eine wirtschaftliche Fertigung von großflächigen Modulen möglich wird, wobei hinsichtlich der zu versiegelnden bzw. zu verkapselnden Flächen Grenzen kaum gegeben sind.

Weitere Einzelheiten und Vorteile der Erfindung ergeben sich aus den Ansprüchen und den diesen zu entnehmenden Merkmalen -für sich und/oder in Kombination-.

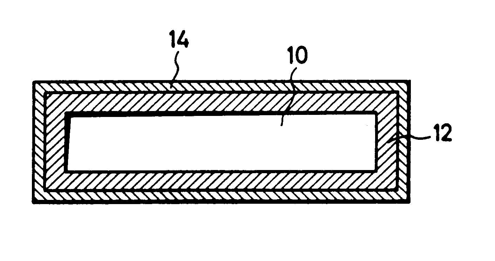

An Hand der nachfolgenden Beschreibung eines der Zeichnung zu entnehmenden Ausführungsbeispiels ergeben sich weitere Einzelheiten, Vorteile und Merkmale der Erfindung.

In der einzigen Figur ist rein schematisch ein photovoltaisches Element (10) dargestellt. Bei dem photovoltaischen Element (10) kann es sich um eine Dünnschichtzelle auf der Basis von amorphem Silizium oder anderen im physikalischen Sinn direkt absorbierende Halbleitermaterialien bzw. Dickschichtzellen auf der Basis von mono- oder polykristalinem Silizium oder anderen im physikalischen Sinne indirekt absorbierenden Halbleitermaterialien handeln. Dabei weist das photovoltaische Element einen bekannten Aufbau auf, wie er z.B. an Hand einer Vielzahl von Beispielen in "Lippold/Trogisch/Friedrich, Solartechnik, Ernst, Verlag für Architektur und technisches Wissen, 1974" beschrieben ist.

Erfindungsgemäß ist die Solarzelle (10) ganzflächig verkapselt, und zwar im Ausführungsbeispiel durch die Schutzschichten (12) und (14). Bei den Schichten (12) und (14) handelt es sich erfindungsgemäß zum einen um eine Schicht aus amorphem Kohlenstoff (a-C:H), kristallinem Kohlenstoff (c-C), amorphem Siliziumoxinitrid (a-SiN$_x$:H) oder kristallinem Siliziumnitrid, die aus der Gasphase auf der Außenfläche des photovoltaischen Elementes (10) abgeschieden werden.

Das Abscheiden der Schichten (12) bzw. (14) soll an Hand der nachstehenden Beispiele näher erläutert werden.

Beispiel A:

Die fertige Solarzelle (10) -diese kann auch durch ein Solarzellenmodul ersetzt werden- wird in einem Reaktionsraum angeordnet, um in einer Plasmaglimmentladung mit amorphem Kohlenstoff beschicht zu werden. Hierzu wird Hochfrequenz im Bereich von 2,3 bis 13,56 MHz kapazitiv eingekoppelt. Die Solarzelle (10) befindet sich auch einer ungeerdeten Elektrode und nimmt eine Vorspannung V$_e$ im Bereich von -10 V bis -900 V an. Vorzugsweise sollten die Parameter so eingestellt werden, daß die Vorspannung V$_e$ im Bereich von -100 V zu liegen kommt. Der Reaktionsbehälter wird an eine Kohlenwasserstoffquelle wie z.B. Methan, Äthan, Butan, Propan, Acetylen, Ethylen, Propylen, Cyclohexan, Octon, Dekan, Xylan, Naphtalin oder ähnliches angeschlossen, wobei der Druck im Reaktionsraum auf in etwa 5 Pa (= 5x10$^{-5}$ bar) eingestellt wird. Die Abscheiderate sollte im Bereich von 0,15 bis 3 nm/s in Abhängigkeit von der verwendeten Kohlenwasserstoffquelle liegen. Bei durchgeführten Versuchen betrug der Elektrodenabstand 3 cm und die Hochfrequenzleistung 1 W/cm$^2$ bei einer Flächengröße der Solarzelle von 100 cm$^2$. Unter diesen Bedingungen ließen sich Schichten mit einer Dicke im Bereich von 0,5 bis 10 $\mu$m, vorzugsweise 1 bis 2 $\mu$m erzielen, wobei die Substrattemperatur bei 80°C lag. Als Ergebnis konnte festgestellt werden, daß sich eine ausreichende Kratzfestigkeit und Härte der Schicht (1000 Hv) bei gleichzeitig genügend hohem Bandabstand (1,8 eV) ergab, um die optischen Veluste zu minimieren. Darüberhinaus zeichnen sich die gewählten Abscheideparameter dadurch aus, daß die erzeugten Schichten mit einem Brechungsindex von n = 2,0 als Antireflexionsschichten dienen.

Auf die Kohlenstoffschicht wird sodann eine Schicht aus einer dielektrischen Siliziumverbindung aufgebracht, beispielhaft nach der folgenden Verfahrensweise.

Beispiel B:

An Stelle einer aus amorphem Kohlenstoff bestehenden Schutzschicht wurde eine unverkapselte Solarzelle zum Schutz gegen Beeinflussungen zunächst mit amorphem Siliziumoxynitrid allseitig beschichtet. Hierzu wurde die Solarzelle in ein mit pyrogenem Graphit beschichtetes Graphitboot, das sich innerhalb eines Quarzrohres befindet, einem Silan-Ammoniak-Plasma ausgesetzt. Die Gasdurchsatzmengen wurden auf 230 cm$^3$/min für Silan und 1750 cm$^3$/min für Ammoniak gewählt. Der Druck im Reaktionsbehälter belief sich während der Abscheidung auf in etwa 100 Pa (= 0,8 Torr). Die Temperatur der Solarzelle (Substrattemperatur) wurde zwischen 200°C und 450°C, vorzugsweise zwischen 260°C und 280°C eingestellt. Die Hochfrequenzleistung im Bereich zwischen 50 und 500 KHz beläuft sich zwischen 50 und 1000 W/m$^2$. Typischerweise ergaben sich 80 W/m$^2$ bei einer Frequenz von 400 KHz. Unter diesen Parametern ergaben sich Siliziumnitridschichten der Dicken zwischen 100 und 10.000 nm. Bevorzugterweise sollten die Schichtdicken zwischen 1000 und 1500 nm liegen. Der Brechungsindex betrug 1,95, so daß sich nicht nur eine Diffusionsbarriere gegen schädliche Umwelteinflüsse ergab, sondern auch eine Antireflexionsschicht.

Die sich anschließende Schicht aus Kohlenstoff kann nach dem Beispiel A aufgebracht werden.

Beispiel C:

Nach einem weiteren Ausführungsbeispiel wird unmittelbar auf die Solarzelle die Siliziumnitridschicht mit einer Dicke zwischen 1000 und 5000 nm aufgetragen. Zur Erhöhung der Kratzfestigkeit und der Härteeigenschaften wurde sodann eine 300 bis 800 nm dicke amorphe Kohlenstoffschicht aufgebracht. Das Auftragen der einzelnen Schichten erfolgte dabei entsprechend der Ausführungsbeispiele A und B.

Beispiel D:

Anstelle der beispielhaft erwähnten jeweiligen amorphen Schicht kann auch eine entsprechende kristalline Schicht Verwendung finden. Die korrespondierende kristalline Schichtdicke ist dabei um den Faktor 2-10, vorzugsweise 4-6 zu erhöhen. (Schichtdicke der kristallinen Siliziumnitridschicht im Bereich 2 und 50$\mu$m und der kristallinen Kohlenstoffschicht im Bereich 0,6 und 8$\mu$m).

**Patentansprüche**

1. Verkapselung von einem photovoltaischen Element (10) wie Solarzelle oder Solarzellenmodul, wobei zumindest dessen freie Außenfläche mit einer transparenten Schutzschicht abgedeckt ist, die eine aus einer dielektrischen Siliziumverbindung (12) bestehende Schicht enthält,
**dadurch gekennzeichnet**,
daß die Außenfläche des photovoltaischen Elementes (10) mit zwei übereinander angeordneten Schichten (12, 14) abgedeckt ist, von denen die eine Schicht (12) aus der dielektrischen Siliziumverbindung und die andere Schicht (14) aus Kohlenstoff besteht.

2. Verkapselung nach Anspruch 1,
**dadurch gekennzeichnet**,
daß die äußere Schicht (14) aus dem Kohlenstoff und die innenliegende Schicht (12) aus der dielektrischen Siliziumverbindung vorzugsweise aus Siliziumnitrid oder Siliziumoxinitrid besteht.

3. Verkapselung nach Anspruch 1,
**dadurch gekennzeichnet**,
daß die aus Kohlenstoff bestehende Schicht (14) amorph oder kristallin ausgebildet ist.

4. Verkapselung nach Anspruch 1,
**dadurch gekennzeichnet**,
daß die Dicke einer jeden amorphen Schicht (12, 14) kleiner als 10 $\mu$m, die Summe der zwei Schichten kleiner als 15 $\mu$m ist.

5. Verkapselung nach Anspruch 3,
**dadurch gekennzeichnet**,
daß die Dicke der Schicht (12) aus amorphem Kohlenstoff kleiner als 1 $\mu$m und die Dicke der Schicht aus der Siliziumverbindung kleiner als 5 $\mu$m ist.

6. Verfahren zur Herstellung einer Verkapselung von einem photovoltaischen Element wie Solarzelle oder Solarzellenmodul gemäß Anspruch 1,
**dadurch gekennzeichnet**,
daß durch plasma- bzw. mikrowellengestütztes Abscheiden aus der Gasphase (CVD) die dielektrische Siliziumverbindung in Form von Siliziumnitrid- oder -oxinitrid-Schicht bei maximal 500°C des photovoltaischen Elementes und eine amorphe Kohlenstoffschicht bei maximal 200°C des photovoltaischen Elementes aufgetragen wird.

**Claims**

1. Encapsulation of a photovoltaic element (10) such as a solar cell or solar cell module, of which at least the free outer surface is covered by a transparent protective film comprising a film made of a dielectric silicon compound (12),
**characterized in that**
the outer surface of the photovoltaic element (10) is covered by two films (12, 14) arranged one above the other, of which one film (12) comprises the dielectric silicon compound and the outer film (14) comprises carbon.

2. Encapsulation according to Claim 1,
**characterized in that**
the outer film (14) comprises carbon and the inner film (12) comprises the dielectric silicon compound, preferably silicon nitride or silicon oxynitride.

3. Encapsulation according to Claim 1.
**characterized in that**
the film (14) comprising carbon is designed amorphous or crystalline.

4. Encapsulation according to Claim 1,
**characterized in that**

the thickness of each amorphous film (12, 14) is less than 10 µm, and the sum of the two films less than 15 µm.

5. Encapsulation according to Claim 3,
**characterized in that**
the thickness of film (12) of amorphous carbon is less than 1 µm, and the thickness of the silicon compound film is less than 5 µm.

6. A method for producing a encapsulation of a photovoltaic element such as a solar cell or solar cell module according to claim 1,
**characterized in that**
by plasma- or microwave-assisted deposition from the gas gas phase (CVD) the dielectric silicon compound in the form of a silicon nitride or silicon oxynitride film is applied at a maximum of 500° C at the photovoltaic element, and an amorphous carbon film applied at a maximum of 200° C at the photovoltaic element.

**Revendications**

1. Blindage d'un élément photovoltaïque (10) tel qu'une cellule solaire ou un module de cellule solaire, au moins sa surface libre extérieure étant recouverte d'une couche de protection transparente qui contient une couche faite d'un composé diélectrique au silicium (12),
**caractérisé en ce que**
la surface extérieure de l'élément photovoltaïque (10) est recouvert de deux couches superposées (12, 14) dont l'une (12) est faite d'un composé diélectrique au silicium et l'autre (14) de carbone.

2. Blindage suivant la revendication n° 1
**caractérisé en ce que**
la surface extérieure (14) est faite du carbone et la couche interne (12) du compose diélectrique au silicium, de préférence de niture de silicium ou d'oxynitrure de silicium.

3. Blindage suivant la revendication n° 1
**caractérisé en ce que,**
la couche (14) faite de carbone est de configuration amorphe ou cristalline.

4. Blindage suivant la revendication n° 1
**caractérisé en ce que**
l'épaisseur de chaque couche amorphe (12, 14) est inférieure à 10 µm, la somme des deux couches étant elle inférieure à 15 µm.

5. Blindage suivant la revendication n° 3,
**caractérisé en ce que**
l'épaisseur de la couche (12) faite de carbone amorphe est inférieure à 1 µm et l'épaisseur de la couche faite du composé au silicium est inférieure à 5 µm.

6. Procédé de fabrication du blindage d'un élément photovoltaïque tel qu'une cellule solaire ou un module de cellule solaire suivant la revendication n° 1,
**caractérisé en ce que,**
par séparation de la phase gazeuse (CVD), assistée par du plasma ou des micro-ondes, le composé diélectrique au silicium est appliqué sous la forme d'une couche de nitrure de silicium ou d'oxynitrure, la température de l'élément photovoltaïque étant au maximum de 500 ° C ou d'une couche de carbone amorphe, la température de l'élément photovoltaïque étant au maximum de 200 ° C.